# EUROPÄISCHE PATENTSCHRIFT

(11) **EP 0 304 611 B1**
(45) Veröffentlichungstag und Bekanntmachung des Hinweises auf die Patenterteilung: **29.09.1993**
(21) Anmeldenummer: 88111467.2
(22) Anmeldetag: 16.07.1988
(51) Int. Cl.: H04N 5/76

(54) **Schaltungsanordnung zur Verteilung eines Antennensignals**
Circuit arrangement for antenna signal distribution
Montage de circuits pour la distribution de signaux d'antenne

(30) Priorität: 26.08.1987 DE 3728381
(43) Veröffentlichungstag der Anmeldung: 01.03.1989
(73) Patentinhaber: Deutsche Thomson-Brandt GmbH, 78003 Villingen-Schwenningen (DE)
(72) Erfinder: Maier, Gerhard, D-7735 Dauchingen (DE); Fischer, Bertram, D-7212 Deisslingen (DE)

(56) Entgegenhaltungen:
- US-A- 3 824 335
- US-A- 4 316 217
- ELECTRONIC APPLICATIONS BULLETIN, Band 33, Nr. 1, Juli 1975, Seiten 1-11; A.C. SMAAL: "Tv receivers as domestic video accessories"

## Beschreibung

Die Erfindung betrifft eine Schaltungsanordnung zur Verteilung eines Antennensignals auf die Eingänge zweier Verbraucher, wobei an einem Eingang eines Verbrauchers ein in seiner Frequenz veränderbarer Modulator geschaltet ist.

Eine derartige Anordnung ist z.B. beim Anschluß eines Videorecorders an einen Fernsehempfänger üblich, indem das Antennensignal über einen im Videorecorder eingebauten Richtkoppler einerseits an den Antenneneingang des Tuners im Fernsehempfänger und andererseits an den Antenneneingang des Tuners im Videorecorder angelegt ist. Parallel zum Antenneneingang des Fernsehempfängers ist ein Modulator geschaltet, der die Video-und Audiosignale eines Videorekordersignals in eine im Fernsehempfangsband liegende Frequenz umsetzt. Im Abstimmbereich des Modulators liegen häufig Sender, die sich den über den Modulator eingespeisten Signalen aus dem Videorecorder überlagern, wodurch auf dem Bildschirm Störungen in Form von Moire-Streifen sichtbar werden. Der Modulator ist in seiner Frequenz veränderbar, jedoch können die Störungen bei ein und derselbem Einstellung der Modulatorfrequenz nicht für sämtliche Kanäle eliminiert werden. Man kann diese Störungen dadurch vermeiden, indem man bei Videorekorderbetrieb sämtliche Fernsehkanäle abschaltet, bzw. den Antenneneingang des Videorekorders durch einen Schalter abschaltbar macht. Dazu benötigt man jedoch einen HF-Schalter, der für den Bereich von 50 bis 900 MHz geeignet sein muß. Dies ist jedoch sehr unpraktisch und kostspielig.

Der Erfindung liegt die Aufgabe zugrunde, die Störungen ohne Zuhilfenahme eines derartigen Schalters zu vermeiden. Diese Aufgabe wird durch die im Patentanspruch angegebene Erfindung gelöst.

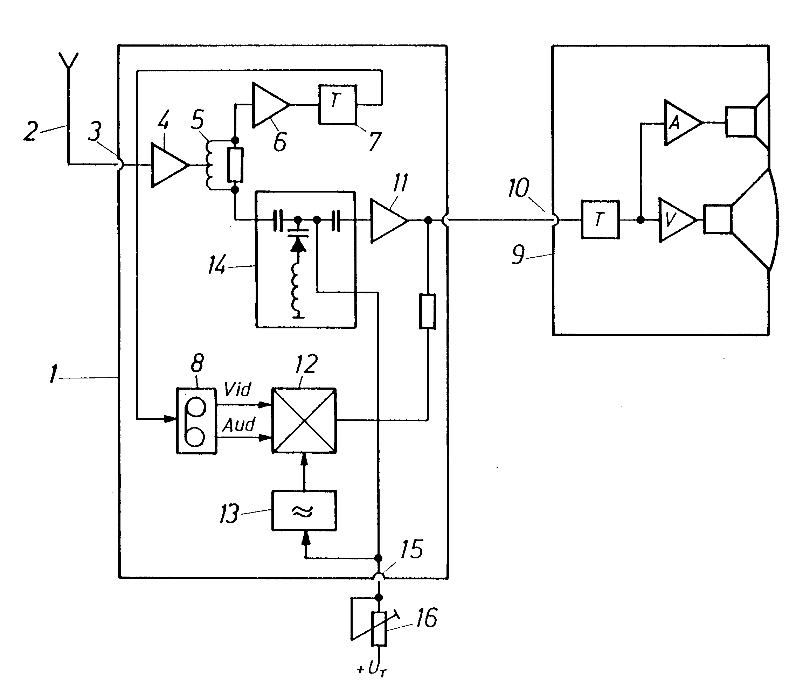

Nachfolgend wird die Erfindung mit Hilfe der Figur näher beschrieben.

Mit 1 ist ein Videorecorder bezeichnet, welcher die von einer Antenne 2 an den Antenneneingang 3 gelegten Antennensignale über einen Antennensignalvorverstärker 4 und einen Richtkoppler 5 sowie einen Verstärker 6 an den Tuner 7 liefert. Diese Signale werden nach Verarbeitung auf ein ein Magnetband 8 aufgezeichnet. Zur Wiedergabe von Fernsehsignalen auf dem Bildschirm eines Fernsehempfängers 9 werden die Antennensignale über den Richtkoppler 5 und einen Verstärker 11 an den Antenneneingang 10 des Fernsehempfängers 9 geleitet. Für die Wiedergabe von aufgezeichneten Video- und Audiosignalen werden diese über einen Modulator 12 an den Antenneneingang 10 gelegt. Die Trägerfrequenz des Modulators 12 ist in gewissen Grenzen mit Hilfe eines Oszillators 13 veränderbar, um diesen auf einen Empfangskanal des Fernsehempfängers 9 abzustimmen. Gemäß Erfindung ist in den den Fernsehempfänger 9 speisenden Teil ein Dämpfungsglied 14 geschaltet. Das Dämpfungsglied ist hier eine Frequenzfalle, deren Fallenfrequenz gleichlaufend mit der Modulatorfrequenz ist. Hierzu wird die über ein Stellglied 16 über einen Eingang 15 zur Abstimmung des Oszillators 13 gelegte Abstimmspannung gleichzeitig an das Dämfpungsglied 14 gelegt, wobei diese Abstimmspannung die Fallenfrequenz mit der Abstimmung des Oszillators 13 mitlaufend verstellt. Dadurch ist gewährleistet, daß das Antennensignal jeweils optimal abgesenkt ist, unabhängig von der Oszillatorabstimmung, so daß auch jegliche Beeinflussung zwischen Antennensignal und Modulatorsignal entfällt.

## Patentansprüche

1. Schaltungsanordnung zur Verteilung eines Antennensignals auf die Antennen-Eingänge zweier Verbraucher über einen Richtkoppler, wobei der Ausgang des ersten Verbrauchers über einen Modulator an den Antennen-Eingang des zweiten Verbrauchers geschaltet ist und die Modulatorfrequenz abstimmbar ist, **dadurch gekennzeichnet,** daß zwischen den Richtkoppler (5) und den Eingang (10) des zweiten Verbrauchers (9) ein Dämpfungsglied (14) geschaltet ist, das eine Fallenfrequenz aufweist, die mit der Modulatorfrequenz identisch und mit der Modulatorfrequenzabstimmung mitlaufend ist.

## Claims

1. A circuit arrangement for the distribution of an aerial signal to the aerial inputs of two consuming units via a directional coupler, the output of the first consuming unit being connected via a modulator to the aerial input of the second consuming unit and the modulator frequency being tunable, characterised in that between the directional coupler (5) and the input (10) of the second consuming unit (9) there is connected an attenuating member (14) which has a trap frequency which is identical with the modulator frequency and follows the modulator frequency tuning.

## Revendications

1. Montage de circuit pour la répartition d'un signal d'antenne aux entrées d'antenne de deux récepteurs par un coupleur directif, la sortie du premier récepteur étant commutée par un modulateur à l'entrée d'antenne du second récepteur et la fréquence du modulateur pouvant être accordée, **caractérisé en ce** qu'un atténuateur (14) est monté entre le coupleur directif (5) et l'entrée (10) du second récepteur (9), atténuateur qui présente une fréquence de piège qui est identique à la fréquence du modulateur et qui est en ligne avec l'accord de la fréquence du modulateur.
